**Europäisches Patentamt**

**European Patent Office**

**Office européen des brevets**

(11) Veröffentlichungsnummer: **0 504 713 A1**

# EUROPÄISCHE PATENTANMELDUNG

(21) Anmeldenummer: **92104095.2**

(22) Anmeldetag: **10.03.92**

(51) Int. Cl.5: **H05K 5/04**

(30) Priorität: **12.03.91 DE 9102937 U**

(43) Veröffentlichungstag der Anmeldung:
**23.09.92 Patentblatt 92/39**

(84) Benannte Vertragsstaaten:
**DE ES FR GB IT NL SE**

(71) Anmelder: **HERRMANN GmbH**
**Industriegebiet Herste**
**W-3490 Bad Driburg(DE)**

(72) Erfinder: **Herrmann, Manfred**
**Industriegebiet Herste**
**W-3490 Bad Driburg(DE)**

(74) Vertreter: **Fincke, Karl Theodor, Dipl.-Phys. Dr.**
**et al**
**Patentanwälte H. Weickmann, Dr. K. Fincke**
**F.A. Weickmann, B. Huber Dr. H. Liska, Dr. J.**
**Prechtel, Dr. B. Böhm, Kopernikusstrasse 9,**
**Postfach 860820**
**W-8000 München 86(DE)**

(54) **Vorrichtung zur Aufnahme einer Batterieanordnung und einer zugehörigen Schaltungsanordnung.**

(57) Die Erfindung betrifft eine Vorrichtung zur Aufnahme einer Batterieanordnung und einer zugehörigen Schaltungsanordnung in einem Gehäuse, dadurch gekennzeichnet, daß das Gehäuse unterseitig und oberseitig Schubverbindungsflächen zum quer zur Schubrichtung formschlüssigen Verbinden mit einem gleichartig ausgebildeten weiteren Gehäuse aufweist.

Fig.1

EP 0 504 713 A1

Die Erfindung betrifft eine Vorrichtung zur Aufnahme einer Batterieanordnung und einer zugehörigen Schaltungsanordnung in einem Gehäuse.

Die Vorrichtung soll insbesondere zur Speisung von Funkgeräten, Navigationsgeräten, Lampen, Scheinwerfern, Meßgeräten, Rechnern, Wasserpumpen, Gasheizgeräten, Luftkompressoren, Alarmanlagen, Telefongeräten, Fernsehgeräten, Radiogeräten, Ladegeräten und als Starthilfe für Benzinmotoren und Dieselmotoren dienen.

Aufgabe der Erfindung ist es, eine solche Vorrichtung in kompakter Weise zu vergrößern oder zu erweitern.

Zur Lösung dieser Aufgabe ist die Vorrichtung dadurch gekennzeichnet, daß das Gehäuse unterseitig und oberseitig Schubverbindungsflächen zum quer zur Schubrichtung formschlüssigen Verbinden mit einem gleichartig ausgebildeten weiteren Gehäuse aufweist. Dieses weitere Gehäuse kann seinerseits eine Batterieanordnung enthalten, aber auch eine Schaltungsanordnung, wie einen Wechselrichter oder dergleichen.

Durch die Schubverbindungsflächen sind die Gehäuse kompakt übereinander steckbar und dabei - aus Gründen der rationellen Fertigung - gleichartig auszubilden.

Eine Schaltungsanordnung befindet sich bevorzugt im wesentlichen in einer auf eine Vorderseite des Gehäuses aufgesetzten Kappe. Die Kappe kann außenseitig bündig zum Umriß des Gehäuses verlaufen. Ein zu weites Aufschieben der Kappe auf das Gehäuse wird durch eine innere Konizität der Kappe in Zusammenwirken mit einer entsprechenden äußeren Konizität des vorderen Endes des Gehäuses und einen Anschlag verhindert. Die Sicherung der Kappe an dem Gehäuse kann durch Madenschrauben als Klemmen an der Rückseite von Schub-Schlitzen erfolgen. Die rückwärtige obere Kante der Kappe kann - in einer anderen Ausführungsform - auch einen Anschlag für das weitere Gehäuse bilden.

Zur Betätigung der Schaltungsanordnung in der Kappe weist bevorzugt die Kappe ein Feld mit einer wasserdichten Folientastatur und Anschlußbuchsen auf.

In einer besonders einfach herstellbaren Ausführungsform sind die Schubverbindungsflächen Seitenflächen von wenigstens einem oberen schwalbenschwanzförmigen Ansatz und wenigstens einer unteren schwalbenschwanzförmigen Vertiefung.

Um die Unterseite des unteren Gehäuses abzudecken, ist bevorzugt eine Bodenplatte mit Schubverbindungsflächen zum quer zur Schubrichtung formschlüssigen Verbinden mit den unteren Schubverbindungsflächen des Gehäuses vorgesehen. Ein Aufnahmeraum für Kabelklemmen oder dergleichen läßt sich dabei dadurch schaffen, daß die Bodenplatte mit der Unterseite des Gehäuses einen nach vorne offenen Raum begrenzt.

Um Batterien oder Schaltungsanordnungen in dem Gehäuse miteinander zu verbinden, befinden sich bevorzugt in der Rückseite des Gehäuses unten und oben zu Steckerbuchsen im Gehäuse führende Öffnungen, in die Kurzschlußverbinder zu stecken sind.

Um das Gehäuse tragbar zu machen, befinden sich bevorzugt an den Seiten des Gehäuses Halteglieder für einen Tragegurt.

Um die Oberseite des Gehäuses an einem Träger befestigen zu können, ist bevorzugt eine an der Unterseite eines Trägers befestigbare Deckelplatte mit Schubverbindungsflächen zum quer zur Schubrichtung formschlüssigen Verbinden mit den oberen Schubverbindungsflächen des Gehäuses vorgesehen.

Um zum Ein- und Ausschalten der Schaltungsanordnung einen Transistor verwenden zu können, die Batterieanordnung aber nicht ständig, also auch im ausgeschalteten Zustand, mit dem Sperrstrom des Transistors zu belasten, weist die Schaltungsanordnung bevorzugt eine zwischen den Polen einer Gleichspannungsquelle liegende Reihenschaltung eines Kondensators, einer Wicklung eines Relais und einer Emitter-Kollektor-Strecke eines Transistors auf; die Basis dieses Transistors ist über einen dem Ein- und Ausschalten dienenden Tastschalter mit einem Pol der Spannungsquelle verbunden; bei Tasten des Tastschalters wird die Emitter-Kollektor-Strecke des Transistors durchgeschaltet; es ist ein durch Erregung der Wicklung des Relais zu schließender Schalter parallel zu dem Kondensator gelegt; ein Anschlußknoten zur Speisung des Rests der Schaltungsanordnung ist zwischen dem Kondensator und der Wicklung des Relais vorgesehen.

Damit die Schaltungsanordnung mit Sicherheit nach einer vorgegebenen Zeit abgeschaltet wird, ist der Anschlußknoten mit der Basis des Transistors über einen Zeitgeber verbunden, der nach Ablauf einer vorgegebenen Zeitspanne seit dem Beginn des Tastens des Tastschalters die Emitter-Kollektor-Strecke des Transistors sperrt.

Die Erfindung wird im folgenden an einem Ausführungsbeispiel unter Hinweis auf die beigefügten Zeichnungen beschrieben.

Fig. 1 zeigt ein Gehäuse perspektivisch.

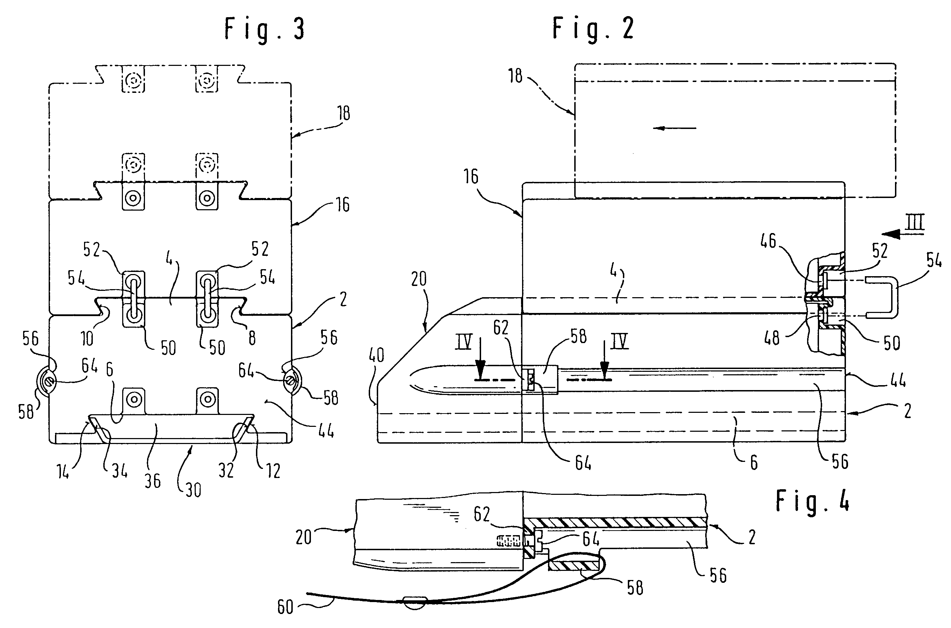

Fig. 2 zeigt das Gehäuse nach Fig.1 mit zwei übereinander aufzusteckenden gleichartigen Gehäusen.

Fig. 3 zeigt eine Rückansicht der Gehäuse aus der Blickrichtung III in Fig. 4.

Fig. 4 zeigt einen Schnitt längs der Linie IV-IV.

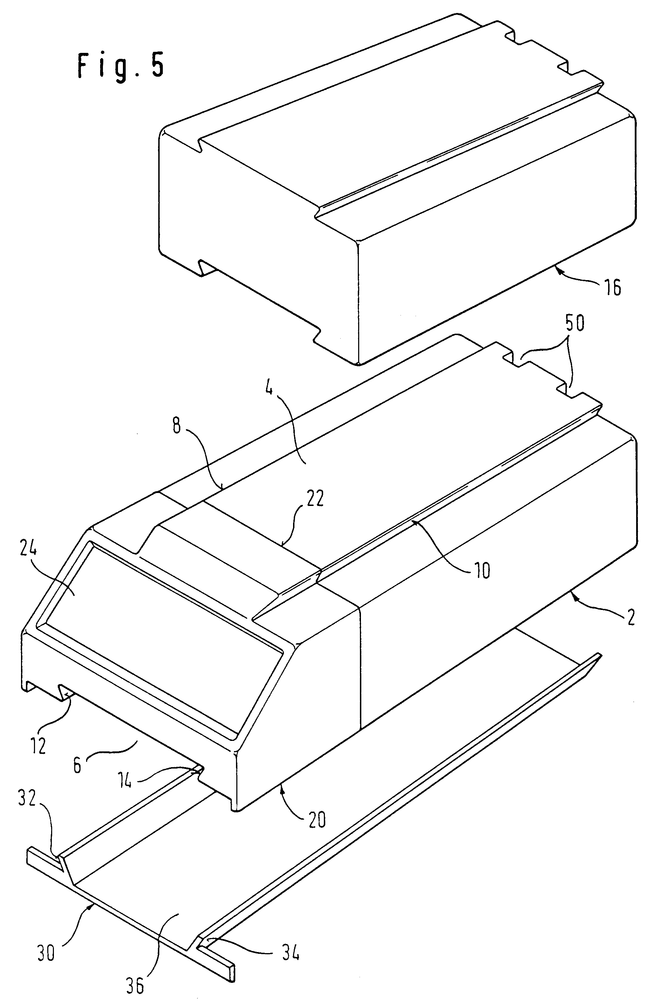

Fig. 5 zeigt in Explosionsdarstellung ein Gehäuse mit einem aufschiebbaren oberen Gehäuse und einer unteren Bodenplatte.

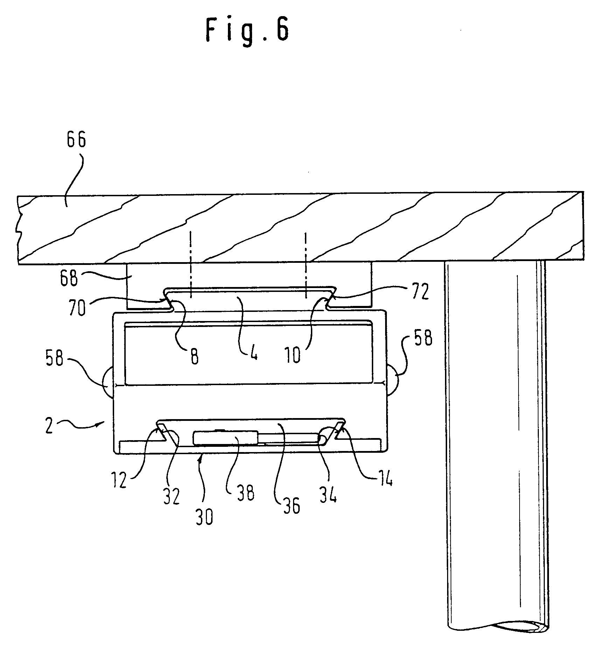

Fig. 6 zeigt die Befestigung eines Gehäuses an der Unterseite eines Tisches.

Fig. 7 zeigt eine Ausführung der Schaltungsanordnung.

Das Basisgehäuse 2 weist oben einen schwalbenschwanzförmigen Ansatz 4 und unten eine schwalbenschwanzförmige Vertiefung 6 mit Seitenflächen 8, 10, 12, 14 auf, die als Schubverbindungsflächen zum quer zur Schubrichtung formschlüssigen Verbinden mit einem gleichartig ausgebildeten weiteren Gehäuse 16 dienen, auf das dann bei Bedarf noch ein drittes Gehäuse 18 aufschiebbar ist. Eine Schaltungsanordnung befindet sich im wesentlichen in einer auf eine Vorderseite des Gehäuses aufgesetzten Kappe 20, deren rückwärtige obere Kante 22 einen Anschlag für das weitere Gehäuse 16 bildet. Die Kappe 20 weist ein schräg nach oben weisendes Feld 24 mit einer wasserdichten Folientastatur 26 und Anschlußbuchsen 28 auf.

Zum Abdecken der Unterseite des Gehäuses ist eine Bodenplatte 30 mit Schubverbindungsflächen 32, 34 vorgesehen, mittels denen die Bodenplatte 30 quer zur Schubrichtung formschlüssig mit den unteren Schubverbindungsflächen 12,14 des Gehäuses 2 zu verbinden ist. Die Bodenplatte 30 begrenzt mit der Unterseite des Gehäuses 2 einen nach vorne offenen Raum 36 zur Aufnahme u. a. von Kabelklemmen 38 oder dergleichen. Oberhalb dieses Raums 36 befindet sich in der Frontseite 40 der Kappe 20 eine Öffnung 42 zur Aufnahme einer Sicherung.

In der Rückseite 44 des Gehäuses 2 sind unten und oben zu Steckbuchsen 46, 48 im Gehäuse führende Öffnungen 50, 52 vorgesehen, in die Kurzschlußverbinder 54 zu stecken sind.

An den Seiten des Gehäuses 2 befinden sich Vertiefungen 56, die im vorderen Bereich von Haltegliedern 58 nach Art von Ösen für einen Tragegurt 60 abgedeckt sind. Nach vorne sind die Vertiefungen 56 durch Flansche 62 begrenzt, durch die Schrauben 64 zum Befestigen der Kappe 20 geführt sind.

Zum Befestigen des Gehäuses 2 an der Unterseite eines Tisches 66 ist eine Deckelplatte 68 mit Schubverbindungsflächen 70, 72 zum quer zur Schubrichtung formschlüssigen Verbinden mit den oberen Verbindungsflächen 8, 10 des Gehäuses 2 vorgesehen.

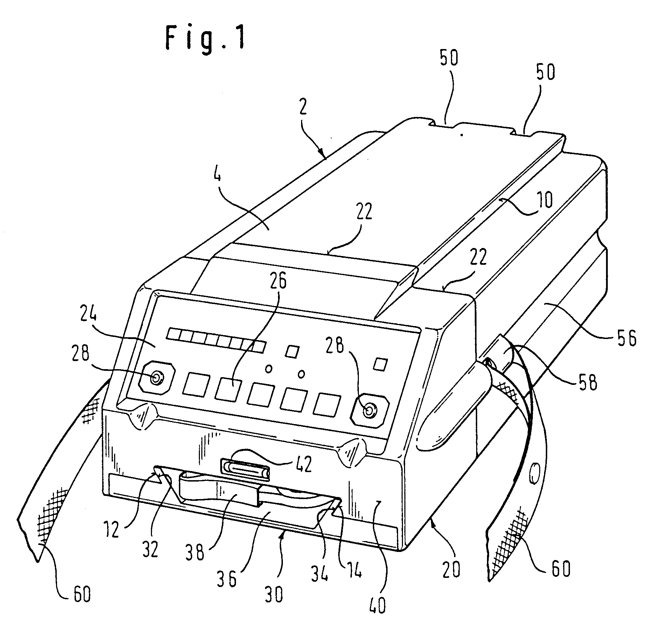

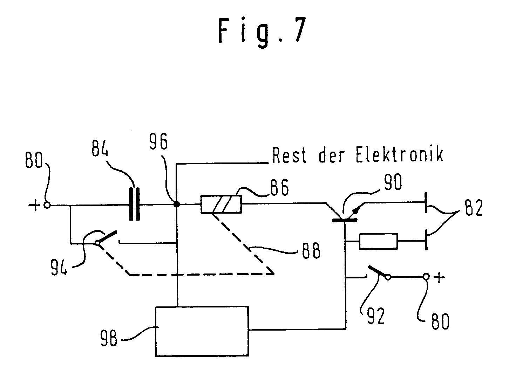

Fig. 7 zeigt eine Schaltungsanorndung mit einer zwischen den Polen 80 (+) und 82 (Masse) einer Gleichspannungsquelle liegenden Reihenschaltung eines Kondensators 84, einer Wicklung 86 eines Relais 88 und einer Emitter-Kollektor-Strecke eines Transistors 90. Die Basis dieses Transistors 90 ist über einen Tastschalter 92 der Folientastatur 26 nach Fig. 1 mit dem Pol 80 der Spannungsquelle verbunden. Bei Tasten des Tastschalters 92 wird die Emitter-Kollektor-Strecke des Transistors 90 durchgeschaltet. Ein durch Erregung der Wicklung 86 des Relais 88 zu schließender Schalter 94 liegt parallel zu dem Kondensator. Ein Anschlußknoten 96, der der Speisung des Rests der Schaltungsanordnung dient, ist zwischen dem Kondensator 84 und der Wicklung 86 des Relais 88 vorgesehen.

Der Anschlußknoten 96 ist mit der Basis des Transistors 90 über einen Zeitgeber 98 verbunden, der nach Ablauf einer vorgegebenen Zeitspanne seit dem Beginn des Tastens des Tastschalters 82 die Emitter-Kollektor-Strecke des Transistors 90 sperrt.

**Patentansprüche**

1. Vorrichtung zur Aufnahme einer Batterieanordnung und einer zugehörigen Schaltungsanordnung in einem Gehäuse (2),
   **dadurch gekennzeichnet,**
   daß das Gehäuse (2) unterseitig und oberseitig Schubverbindungsflächen (8, 10, 12, 14) zum quer zur Schubrichtung formschlüssigen Verbinden mit einem gleichartig ausgebildeten weiteren Gehäuse (16) aufweist.

2. Vorrichtung nach Anspruch 1, dadurch gekennzeichnet, daß sich die Schaltungsanordnung im wesentlichen in einer auf eine Vorderseite des Gehäuses (2) gesetzten Kappe (20) befindet.

3. Vorrichtung nach Anspruch 2, dadurch gekennzeichnet, daß die Kappe (20) ein Feld (24) mit einer wasserdichten Folientastatur (26) und Anschlußbuchsen (28) aufweist.

4. Vorrichtung nach einem der vorstehenden Ansprüche, dadurch gekennzeichnet, daß die Schubverbindungsflächen (8, 10, 12, 14) Seitenflächen (8, 10, 12, 14) von wenigstens einem oberen schwalbenschwanzförmigen Ansatz (4) und wenigstens einer unteren schwalbenschwanzförmigen Vertiefung (6) sind.

5. Vorrichtung nach einem der vorstehenden Ansprüche, dadurch gekennzeichnet, daß eine Bodenplatte (30) mit Schubverbindungsflächen (32, 34) zum quer zur Schubrichtung formschlüssigen Verbinden mit den unteren Schubverbindungsflächen (12, 14) des Gehäuses (2) vorgesehen ist.

6. Vorrichtung nach Anspruch 5, dadurch gekennzeichnet, daß die Bodenplatte (30) mit der Unterseite des Gehäuses (2) einen nach vorne offenen Raum (36) zur Aufnahme u.a. von Kabelklemmen (38) oder dergleichen begrenzt.

7.  Vorrichtung nach einem der vorstehenden Ansprüche, dadurch gekennzeichnet, daß sich in der Rückseite (44) des Gehäuses (2) unten und oben zu Steckerbuchsen (46, 48) im Gehäuse (2) führende Öffnungen (50, 52) befinden, in die Kurzschlußverbinder (54) zu stecken sind.

8.  Vorrichtung nach einem der vorstehenden Ansprüche, dadurch gekennzeichnet, daß sich an den Seiten des Gehäuses (2) Halteglieder (58) für einen Tragegurt (60) befinden.

9.  Vorrichtung nach einem der vorstehenden Ansprüche, dadurch gekennzeichnet, daß eine an der Unterseite eines Trägers (66) befestigbare Deckelplatte (68) mit Schubverbindungsflächen (70, 72) zum quer zur Schubrichtung formschlüssigen Verbinden mit den oberen Schubverbindungsflächen (8, 10) des Gehäuses (2) vorgesehen ist.

10. Vorrichtung nach einem der vorstehenden Ansprüche, dadurch gekennzeichnet, daß die Schaltungsanordnung eine zwischen den Polen (80, 82) einer Gleichspannungsquelle liegende Reihenschaltung eines Kondensators (84), einer Wicklung (86) eines Relais (88) und einer Emitter-Kollektor-Strecke eines Transistors (90) aufweist, daß die Basis dieses Transistors (90) über einen Tastschalter (92) mit einem Pol (80) der Spannungsquelle verbunden ist, der bei Tasten des Tastschalters (92) die Emitter-Kollektor-Strecke des Transistors (90) durchschaltet, daß ein durch Erregung der Wicklung (86) des Relais (88) zu schließender Schalter (94) parallel zu dem Kondensator (84) liegt und daS ein Anschlußknoten (96) zur Speisung des Rests der Schaltungsanordnung zwischen dem Kondensator (84) und der Wicklung (86) des Relais (88) vorgesehen ist.

11. Vorrichtung nach Anspruch 10, dadurch gekennzeichnet, daß der Anschlußknoten (96) mit der Basis des Transistors (90) über einen Zeitgeber (98) verbunden ist, der nach Ablauf einer vorgegebenen Zeitspanne seit dem Beginn des Tastens des Tastschalters (82) die Emitter-Kollektor-Strecke des Transistors (90) sperrt.

# Fig.1

Fig. 2

Fig. 3

Fig. 4

Fig.5

# Fig.6

# Fig.7

| | **EINSCHLÄGIGE DOKUMENTE** | | EP 92104095.2 |
|---|---|---|---|
| Kategorie | Kennzeichnung des Dokuments mit Angabe, soweit erforderlich. der maßgeblichen Teile | Betrifft Anspruch | KLASSIFIKATION DER ANMELDUNG (Int Cl⁵) |
| A | EP - A - 0 382 141 (SCHMITZ) * Zusammenfassung; Fig. 1-8 * -- | 1-11 | H 05 K 5/04 |
| A | EP - A - 0 234 294 (TES) * Zusammenfassung; Fig. 1-8 * -- | 1-11 | |
| A | US - A - 3 956 675 (BAUER) * Zusammenfassung; Fig. 1-9 * -- | 1-11 | |
| A | EP - A - 0 262 776 (ULTICON) * Zusammenfassung; Fig. 1-4 * ---- | 1-11 | |
| | | | **RECHERCHIERTE SACHGEBIETE (Int. Cl⁵)** |
| | | | H 05 K 5/00 |

Der vorliegende Recherchenbericht wurde für alle Patentansprüche erstellt.

| Recherchenort | Abschlußdatum der Recherche | Prüfer |
|---|---|---|
| WIEN | 15-06-1992 | VAKIL |

EPA Form 1503 03 82